(19) Europäisches Patentamt
European Patent Office
Office européen des brevets

(11) Veröffentlichungsnummer: **0 191 400 B1**

(12) **EUROPÄISCHE PATENTSCHRIFT**

(45) Veröffentlichungstag der Patentschrift: **15.01.92**

(51) Int. Cl.5: **G03F 7/016**

(21) Anmeldenummer: **86101413.2**

(22) Anmeldetag: **04.02.86**

# (54) Lichtempfindliches Gemisch und damit hergestelltes Aufzeichnungsmaterial.

(30) Priorität: **12.02.85 DE 3504658**

(43) Veröffentlichungstag der Anmeldung:
**20.08.86 Patentblatt 86/34**

(45) Bekanntmachung des Hinweises auf die Patenterteilung:
**15.01.92 Patentblatt 92/03**

(84) Benannte Vertragsstaaten:
**DE FR GB**

(56) Entgegenhaltungen:
**DE-A- 2 309 062**
**DE-A- 3 329 443**
**GB-A- 1 235 281**

**PATENT ABSTRACTS OF JAPAN, Band 7, Nr. 253 (P-235)[1398], 10. November 1983; & JP-A-58 137 834 (KURARAY K.K.) 16-08-1983**

(73) Patentinhaber: **HOECHST AKTIENGESELLSCHAFT**
**Postfach 80 03 20**
**W-6230 Frankfurt am Main 80(DE)**

(72) Erfinder: **Frommeld, Hans-Dieter, Dr. Dipl.-Chem.**
**Simrockstrasse 7A**
**W-6200 Wiesbaden(DE)**

EP 0 191 400 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein negativ arbeitendes lichtempfindliches Gemisch, das ein polymeres Diazoniumsalz und ein polymeres Bindemittel enthält, sowie ein damit hergestelltes Aufzeichnungsmaterial, das vorzugsweise für die Herstellung von Flachdruckplatten geeignet ist.

Es ist bekannt, die Lebensdauer (Auflagenhöhe) einer Offsetdruckform durch Einbrennen, d.h. durch Erwärmen auf 150 bis 250 °C, zu erhöhen. Dies gilt insbesondere für Positivdruckplatten auf der Basis von Naphthochinondiaziden und Novolaken oder Resolen (Phenolharzen) als Bindemittel, wie sie in der GB-A 1 154 749 beschrieben sind.

Für negativ arbeitende Druckplatten haben sich polymere Diazoniumsalze, insbesondere Diazoniumsalz-Polykondensate, als lichtempfindliche Verbindungen bestens bewährt. Es war jedoch bisher kaum möglich, beim Einbrennen solcher Platten eine nennenswerte Erhöhung der Auflage zu erreichen. In manchen Fällen wurde sogar eine Verminderung der Auflage beobachtet, was möglicherweise durch eine Fragmentierung der Makromoleküle erklärt werden kann.

Es hat sich auch gezeigt, daß die Phenolharze - besonders Novolake - als Bindemittel in den Positivschichten für eine optimale Auflagensteigerung erforderlich sind. Diese Phenolharze sind aber als Bindemittel für die genannten negativ arbeitenden Schichten wenig oder überhaupt nicht geeignet. Lichtempfindliche Gemische aus an sich negativ arbeitenden Diazoniumsalzen und einem Überschuß an Phenolharz arbeiten sogar positiv (DE-B 20 65 732, Beispiele 54 und 55).

Um dennoch Negativdruckplatten einbrennen zu können, hat man sich damit beholfen, die fertig entwickelte Druckform mit einem Phenolharz enthaltenden Lack zu verstärken, der nur von den Bildstellen angenommen wird, und dann diese Platte einzubrennen. Diese Verfahrensweise ist in der GB-A 1 151 199 beschrieben. Sie hat sich in der Praxis nicht durchgesetzt.

In der EP-A 0 111 273 wird ein lichtempfindliches Gemisch beschrieben, das ein in wäßrig-alkalischen Lösungen lösliches Bindemittel, eine lichtempfindliche Substanz und ein Melaminderivat als Vernetzungsmittel enthält. Bevorzugt werden als Bindemittel wieder Novolake. Mit üblichen Mischpolymerisaten aus (Meth)acrylsäure und (Meth)acrylsäureestern ist aber die Vernetzung nicht befriedigend.

In der FR-A 2 485 759 werden Epoxyharze als vernetzende Zusätze zu Diazodipenylamin-Kondensationsprodukten empfohlen. Solche Schichten sind in frischem Zustand gut härtbar. Die Schichten zeigen aber keine befriedigende Lagerfähigkeit.

In der JP-A 58/137 834 (s. Patent Abstracts of Japan, Band 7, Nr. 253, P-235, 1398; 10.11.1983) wird ein lichtempfindliches Gemisch aus einem modifizierten Polyvinylalkohol mit Einheiten der Formel

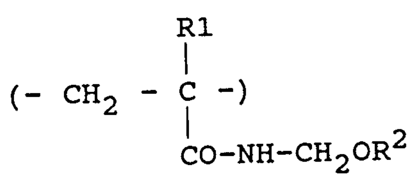

und einem Kondensationsharz von Diphenylamin-4-diazoniumchlorid mit Formaldehyd beschrieben.

In der DE-A 23 09 062 wird eine lichtempfindliche Mischung aus Photoinitiatoren und monomeren N-Methylol-acrylamidderivaten beschrieben, die bei Belichtung polymerisiert und durch anschließendes Erwärmen gehärtet wird.

In der GB-A 1 235 281 werden lichtempfindliche Gemische aus Diazo- oder Azidoverbindungen, z. B. Kondensationsprodukte von 4-Diazo-diphenylamin mit Formaldehyd, und Polymeren von ggf. substituierten Acrylamiden beschrieben, die bei Belichtung ätzfeste Schichten ergeben.

In der älteren, nicht vorveröffentlichten EP-A 141 921 sind photopolymerisierbare Gemische aus polymerisierbaren ethylenisch ungesättigten Verbindungen, Photoinitiatoren und polymeren Bindemitteln beschrieben. Die Bindemittel bestehen mindestens zum Teil aus Polymeren mit seitenständigen vernetzenden Gruppen $-CH_2OR$, worin R eine Alkyl-, Acyl- oder Hydroxyalkylgruppe ist. Die Gemische dienen zur Herstellung von thermisch härtbaren Lötstopmasken.

Aufgabe der Erfindung war es, ein negativ arbeitendes, durch Erhitzen härtbares lichtempfindliches Gemisch zur Herstellung eines lichtempfindlichen Aufzeichnungsmaterials, vorzugsweise für die Herstellung von Flachdruckformen, vorzuschlagen, das sich durch eine gute Auflösung, eine gute Resistenz, d.h. hohe Auflage nach dem Einbrennen, und gute Lagerfähigkeit im unbelichteten Zustand auszeichnet.

Die Erfindung geht aus von einem lichtempfindlichen Gemisch aus einem Diazoniumsalz-Polykondensationsprodukt und einem polymeren Bindemittel, das seitenständige vernetzende Gruppen der Formel $-CH_2-OR$ enthält, worin R ein Wasserstoffatom, eine niedere Alkyl-, Acyl- oder Hydroxyalkylgruppe ist.

Das erfindungsgemäße Gemisch ist dadurch gekennzeichnet, daß das Diazoniumsalz-Polykondensationsprodukt aus wiederkehrenden Einheiten $A-N_2X$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

Das Bindemittel ist bevorzugt ein Mischpolymerisat mit Einheiten der Formel

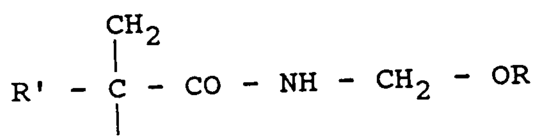

worin

R' ein Wasserstoffatom oder eine Methylgruppe ist und
R die oben angegebene Bedeutung hat.

Wenn R eine Alkylgruppe ist, enthält diese im allgemeinen 1 bis 6, bevorzugt 1 bis 4 Kohlenstoffatome; wenn es eine Acylgruppe ist, hat diese im allgemeinen 1 bis 4, bevorzugt 1 bis 2 Kohlenstoffatome. Verbindungen mit R = Alkyl werden im allgemeinen bevorzugt.

Außer den Einheiten der oben angegebenen Formel kann das Mischpolymerisat weitere Einheiten, vorzugsweise solche, die Polymere mit niedrigem Tg-Wert ergeben, insbesondere Acryl- oder Methacrylsäureestereinheiten enthalten.

Die Polymeren mit den oben bezeichneten Monomereinheiten ergeben beim Erhitzen in Gegenwart von Polymeren mit freien Hydroxyl- oder vorzugsweise Carboxyl- oder Carbonamidgruppen vernetzte Produkte. Sie können demgemäß im Gemisch mit polymeren Bindemitteln vorliegen, die solche Substituenten enthalten. Bevorzugt werden Bindemittel verwendet, die beide Arten von funktionellen Einheiten in einem Molekül enthalten. Als solche kommen Co- oder insbesondere Terpolymerisate von substituierten Acryl- oder Methacrylsäureamiden mit Acryl- oder Methacrylsäureamid, Acryl- oder Methacrylsäure oder mit Alkylestern der Acryl- oder Methacrylsäure in Betracht. Die Methacrylsäureester werden dabei besonders bevorzugt, insbesondere solche mit 4 bis 12 C-Atomen in der Alkylgruppe. Werden Acrylsäureester verwendet, so kann die Alkylgruppe auch kürzer sein.

Zusätzlich können die Polymerisate kleine Mengen an Hydroxyalkylacrylaten oder -methacrylaten einpolymerisiert enthalten.

Der Mengenanteil an Carboxylgruppen und/oder Carbonamidgruppen enthaltenden Einheiten im Mischpolymerisat wird bestimmt durch die Forderung nach störungsfreier und möglichst rascher Entwicklung mit wäßrigen, bevorzugt alkalischen Lösungen, die vorzugsweise frei von organischen Lösemitteln sind, und nach möglichst großer Entwicklerresistenz der belichteten Bereiche. Diese Eigenschaften werden in geringerem Maße auch durch das mittlere Molekulargewicht und die chemische und molekulare Uneinheitlichkeit des Polymeren beeinflußt. Im allgemeinen sollte die Säurezahl im Bereich bis 250, bevorzugt zwischen 50 und 220, liegen. Wenn ein Entwickler verwendet werden soll, der organische Lösemittel enthält, kann die Säurezahl auch kleiner sein.

Die bevorzugten Terpolymerisate enthalten normalerweise etwa 15 bis 60, bevorzugt 20 bis 50 Gew.-% an substituierten Säureamideinheiten. Der Mengenanteil an Acryl- oder Methacrylsäureeinheiten entspricht den oben angegebenen Säurezahlen; er liegt im allgemeinen bei 10 - 35 Gew.-%. Der Anteil an Alkylacrylat bzw. -methacrylat liegt im Bereich von 25 bis 75 Gew.-%. Die Methacrylsäure in freier Form und in Form des Alkylesters wird gegenüber der Acrylsäure bevorzugt.

Die Bindemittel werden bevorzugt durch radikalische Polymerisation in organischen Lösemitteln, z. B. Butanon oder Ethanol, hergestellt.

Der Mengenanteil an Bindemitteln in dem polymerisierbaren Gemisch liegt im Bereich von 1 bis 75, vorzugsweise 5 bis 50 Gew.-%, bezogen auf dessen nichtflüchtige Bestandteile.

Gegebenenfalls können daneben noch niedermolekulare vernetzbare Verbindungen, z.B. Veretherungsprodukte des Hexahydroxymethylmelamins, insbesondere Hexamethoxymethylmelamin, zugesetzt werden. Von diesen Verbindungen können 0,5 bis 30, vorzugsweise bis zu 20 Gew.-%, bezogen auf die nichtflüchtigen Bestandteile des Gemisches, zugesetzt werden.

Diazoniumsalze-Polykondensationsprodukte, wie sie in den erfindungsgemäßen Gemischen enthalten sind, sind Mischkondensationsprodukte, die außer den Diazoniumsalzeinheiten noch andere Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Solche Kondensationsprodukte sind in den DE-A 20 24 244 und 33 11 435 beschrieben.

Die Diazoniumsalzeinheiten $A-N_2X$ leiten sich von Verbindungen der Formel $(R^1-R^2-)_pR^3-N_2X$ ab, wobei

X das Anion der Diazoniumverbindung,
p eine ganze Zahl von 1 bis 3,
$R^1$ einen aromatischen Rest mit mindestens einer zur Kondensation mit aktiver Carbonylverbindung befähigten Position,
$R^3$ eine gegebenenfalls substituierte Phenylengruppe,
$R^2$ eine Einfachbindung oder eine der Gruppen:

$-(CH_2)_q-NR^4-$,
$-O-(CH_2)_r-NR^4-$,
$-S-(CH_2)_r-NR^4-$,
$-S-CH_2CO-NR^4-$,
$-O-R^5-O-$,
$-O-$
$-S-$ oder
$-CO-NR^4-$

bedeuten, worin

q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Die erfindungsgemäßen Gemische können ferner in bekannter Weise polymere Bindemittel, Farbstoffe, Pigmente, Verlaufmittel, Netzmittel und andere übliche Zusätze enthalten.

Die Gemische werden bevorzugt zur Herstellung lichtempfindlicher Druckplatten, insbesondere Flachdruckplatten, eingesetzt. In diesem Fall werden als Schichtträger vorwiegend Metalle, wie Zink, Stahl, verchromter Stahl, Messing/Chrom, Kupfer/Chrom oder Aluminium verwendet. Für Flachdruckplatten wird Aluminium bevorzugt, insbesondere mechanisch, chemisch oder elektrolytisch aufgerauhtes Aluminium, das bevorzugt noch mit einer anodisch erzeugten Oxidschicht versehen ist.

Als Lösemittel zur Bereitung der Beschichtungslösungen können je nach den Schichtbestandteilen z. B. Alkohole, wie Methanol und Ethanol; Glykolether wie Propylenglykolmonoethylether; Dimethylformamid und Diethylformamid, Ether wie Dioxan, Tetrahydrofuran; Ester wie Essigsäureethylester, Butylacetat, Ethylenglykolmethyletheracetat; Ketone wie Methylethylketon, Cyclohexanon usw., verwendet werden.

Bei der Verarbeitung wird das Aufzeichnungsmaterial bildmäßig durch eine Vorlage belichtet. Zur Bildbelichtung kann jede in der Reproduktionstechnik gebräuchliche Lichtquelle dienen, die im langwelligen UV-Bereich emittiert, z. B. Kohlenbogenlampen, Quecksilberhochdrucklampen, Xenonimpulslampen und andere. Auch Elektronen- oder Laserstrahlung ist zur Bildaufzeichnung geeignet.

Nach der Belichtung wird mit einem geeigneten Entwickler entwickelt. Als Entwickler können z. B. wäßrige Netzmittellösungen, gegebenenfalls unter Zusatz von Alkali, deren Gemische mit organischen Lösemitteln, wäßrige Salzlösungen, wäßrige Lösungen von Säuren, z. B. von Phosphorsäuren, denen wiederum Salze oder organische Lösemittel zugesetzt werden können, oder wäßrig-alkalische Entwickler verwendet werden, z.B. wäßrige Lösungen von Natriumsalzen der Phosphorsäure oder der Kieselsäure. Auch diesen Entwicklern können organische Lösemittel zugesetzt werden. Es ist in manchen Fällen auch möglich, mit Wasser verdünnte organische Lösemittel zu verwenden. Die Entwickler können noch weitere Bestandteile, z. B. Netzmittel und Hydrophilierungsmittel, enthalten.

Die Entwicklung erfolgt in bekannter Weise, z. B. durch Tauchen und/oder Überwischen oder Besprühen mit der Entwicklerflüssigkeit. Dabei werden die nicht belichteten Schichtbereiche gelöst.

Die nachstehenden Beispiele beschreiben die Herstellung der erfindungsgemäßen lichtempfindlichen

Gemische und der mit diesen hergestellten Aufzeichnungsmaterialien. In den Beispielen stehen Gewichtsteile (Gt) und Volumenteile (Vt) zueinander im Verhältnis von g zu ml. Prozentangaben sind, wenn nichts anderes angegeben ist, Gewichtsprozente, Temperaturen sind in °C angegeben.

Beispiel 1

Mit einer Lösung von

| | |
|---|---|
| 20 Gt | des Polykondensationsprodukts aus 1 mol 3-Methoxy-diphenylamin-4-diazoniumsulfat und 1 mol 4,4'-Bis-methoxymethyl-diphenylether, ausgefällt als Mesitylensulfonat, |
| 1,8 Gt | Viktoriareinblau FGA (CI 42 595), |
| 1 Gt | $H_3PO_4$ (85%ig) und |
| 6 Gt | eines der im folgenden angegebenen harzartigen Zusätze in |
| 550 Gt | 2-Methoxy-ethanol und |
| 490 Gt | Tetrahydrofuran |

wurde je eine elektrochemisch aufgerauhte und anodisierte Aluminiumplatte beschichtet, die vor dem Aufbringen der Lösung mit einer wäßrigen Lösung von 0,1 Gew.-% Polyvinylphosphonsäure behandelt worden war.

Als Zusätze wurden im einzelnen verwendet:

a) ein Terpolymeres aus N-Butoxymethyl-methacrylsäureamid, Methacrylsäure und Hexylmethacrylat (25:25:50)

b) ein Terpolymeres aus N-Butoxymethyl-methacrylsäureamid, Acrylsäure und Hexylmethacrylat (47:18:35)

c) ein Terpolymeres aus Styrol, Methacrylsäure und Hexylmethacrylat (10:30:60) (Vergleich)

d) der Bisglycidylether des 2,2-Bis(p-hydroxyphenyl)-propans (Vergleich)

Die so hergestellten vorsensibilisierten Druckplatten mit einem Schichtgewicht von jeweils etwa 1,5 $g/m^2$ wurden unter einer transparenten Negativvorlage bildmäßig belichtet und anschließend mit folgender Lösung entwickelt:

| | |
|---|---|
| 2 Gt | Na-dodecylbenzolsulfonat, |
| 1,5 Gt | $K_2CO_3$, |
| 1,5 Gt | $KHCO_3$, |
| 1,4 Gt | KOH, |
| 2,0 Gt | Graham'sches Salz, |
| 4,0 Gt | Pelargonsäure, |
| 2,0 Gt | Poly-N-vinyl-N-methylacetamid, |
| 3,0 Gt | 2-Phenoxy-ethanol, |
| 82,6 Gt | Wasser. |

Die entwickelten Druckplatten wurden in der Mitte geteilt und die eine Hälfte jeweils 5 Minuten auf 230 °C erhitzt.

Anschließend wurde in einer Offsetmaschine gedruckt und die folgende Anzahl einwandfreier Drucke erzeugt:

| | ohne Erhitzen | mit Erhitzen |
|---|---|---|
| a | 100 000 | 150 000 |
| b | 100 000 | 150 000 |
| c | 100 000 | 110 000 |

Die Tabelle zeigt, daß die erfindungsgemäßen Bestandteile eine deutliche Erhöhung der Auflage beim Einbrennen bewirken. Wegen der im folgenden gezeigten schlechten Lagerfähigkeit von d wurde auf einen Druckversuch mit diesem Material verzichtet.

Stücke der Muster a bis d wurden 30 Minuten, 1, 2, 3 und 4 Stunden im Wärmeschrank bei 100 °C gelagert, anschließend unter einer Testvorlage belichtet und wie oben eine Minute entwickelt. Die Druckplatten a bis c waren auch nach 4 Stunden bei 100 °C noch voll brauchbar. Dagegen ließ sich die Platte d bereits nach 30 Minuten bei 100 °C nicht mehr schleierfrei entwickeln.

Eine Probe der Platte d war auch - im Gegensatz zu den Proben a bis c - nach einer 4-wöchigen Lagerung bei Raumtemperatur nicht mehr tonfrei entwickelbar.

Proben der Druckplatten a und c wurden mit einer 5-kW-Metallhalogenidlampe im Abstand von 110 cm unter einer Testvorlage, die einen Halbtonstufenkeil mit Dichteinkrementen von 0,15 sowie Auflösungstestelemente enthielt, belichtet. Je eine Platte a und c wurde

1. nach 10 Minuten Lagerung bei Raumtemperatur mit dem oben beschriebenen Entwickler 1 Minute entwickelt,
2. 10 Minuten auf 100 °C erhitzt und dann entsprechend entwickelt,
3. 10 Minuten auf 120 °C erhitzt und dann entsprechend entwickelt.

In der folgenden Tabelle ist die Zahl der voll gedeckten (vernetzten) Stufen wiedergegeben:

| Behandlung | Muster a | Muster c |
|---|---|---|
| 10 Minuten RT | 2 | 2 |
| 10 Minuten 100 °C | 4 | 2 |
| 10 Minuten 120 °C | 5 | 2 |

Die Tabelle zeigt, daß die Lichtempfindlichkeit des erfindungsgemäßen Materials durch eine Nacherhitzung gesteigert wird. Die belichteten und teilbelichteten Bereiche vernetzen schneller als die unbelichteten. Eine Verminderung der Auflösung wurde nicht beobachtet.

Ähnlich gute Ergebnisse wie im Beispiel 1a wurden erzielt, wenn als polymerer Zusatz

e) ein Copolymerisat aus N-Butoxymethyl-methacrylsäureamid und Acrylsäureamid (85:15) oder

f) ein Terpolymeres aus N-Butoxymethyl-methacrylsäureamid, Acrylsäureamid und Hexylmethacrylat (30:20:50) verwendet wurde.

## Beispiel 2

Mit einer Lösung von

| | |
|---|---|
| 2 Gt | des Polykondensationsprodukts aus 1 mol 3-Methoxydiphenylamin-4-diazoniumsulfat und 1 mol 4,4'-Bis-methoxymethyl-diphenylether, ausgefällt als Tetrafluoroborat, |
| 0,15 Gt | Viktoriareinblau FGA (CI 42 595), |
| 0,2 Gt | Phosphorsäure (85%ig) und |
| 1 Gt | eines der unten angegebenen Polymeren in |
| 30 Gt | Dimethylformamid, |
| 29 Gt | 2-Methoxy-ethanol und |
| 20 Gt | Tetrahydrofuran |

wurde eine durch Drahtbürsten mechanisch aufgerauhte Aluminiumplatte beschichtet und danach 2 Minuten bei 110 °C getrocknet.

Als Polymere wurden eingesetzt:

a) ein Terpolymeres aus n-Hexylmethacrylat, Methacrylsäure und N-Butoxymethyl-methacrylamid (36:28:36)

b) ein Terpolymeres aus n-Hexylmethacrylat, Methacrylsäure und Styrol (60:30:10) (Vergleich)

Die Platten wurden belichtet und je zur Hälfte 5 Minuten auf 210 °C erhitzt. Anschließend wurde die Resistenz gegen Lösemittel geprüft. Mit einem mit Dimethylsulfoxid getränkten Wattebausch wurden die Platten 1 Minute überwischt und dann beurteilt.

| | nicht erhitzt | erhitzt |
|---|---|---|
| a | starker Angriff und Schichtablösung | kein nennenswerter Angriff |
| b | wie a) | Angriff mit Schichtablösung |

Ähnliche Ergebnisse wurden auch mit dem aggressiver wirkenden Dimethylformamid gefunden, d.h. die erfindungsgemäße Schicht ist thermisch vernetzbar und dann resistent.

## Beispiel 3

Mit einer Lösung von

| | |
|---|---|
| 2 Gt | des in Beispiel 1 angegebenen Diazoniumsalz-Polykondensationsprodukts |
| 2 Gt | eines Terpolymeren aus N-Butoxymethyl-methacrylamid, Methacrylsäure und Ethylacrylat (31:32:37) |
| 0,2 Gt | Viktoriareinblau FGA (CI 42 595) und |

| | |
|---|---|
| 0,1 Gt | Phosphorsäure (85%ig) in |
| 50 Gt | 2-Methoxy-ethanol und |
| 35 Gt | Tetrahydrofuran |

wurde eine elektrochemisch aufgerauhte und anodisierte Aluminiumplatte beschichtet. Nach dem Trocknen betrug das Schichtgewicht 1,2 $g/m^2$. Die Druckplatte wurde unter einer Testvorlage belichtet und mit dem Entwickler von Beispiel 1 entwickelt. Eine Hälfte der Platte wurde 5 Minuten auf 230 °C erhitzt.

Die erhitzte und die nicht erhitzte Probe wurden nebeneinander in eine Offsetdruckmaschine eingespannt. Beim vergleichenden Auflagendruck liefen die unter einem Graustufenkeil teilbelichteten Teile auf der nicht nacherhitzten Platte sehr viel schneller ab als auf der erhitzten Platte. Ab 110.000 bis 120.000 Drucken wurde die nicht erhitzte Platte unbrauchbar, sie gab nur noch flaue, graue Drucke, während die erhitzte Platte nach wie vor gute Detailwiedergabe bei voller Farbübertragung zeigte.

Vergleichbare Ergebnisse wurden auch mit Terpolymerisaten aus N-Butoxymethyl-methacrylamid, Methacrylsäure und Decylmethacrylat (23:30:47) oder N-Butoxymethyl-methacrylamid, Acrylsäure und Hexylmethacrylat (26:22:52) erzielt.

Beispiel 4

Mit einer Lösung von

| | |
|---|---|
| 2 Gt | eines Mischkondensats aus 1 mol 3-Methoxydiphenylamin-4-diazoniumsulfat, 1 mol 4-Methoxymethyl-4'-methyl-diphenylether und 1 mol 4,4'-Bis-methoxymethyl-diphenylether, ausgefällt als Mesitylensulfonat, |
| 0,2 Gt | eines Terpolymerisats aus Styrol, n-Hexylmethacrylat und Methacrylsäure (10:60:30; Molgewicht 35.000), |
| 0,1 Gt | eines Copolymerisats aus N-Methoxymethyl-methacrylamid und n-Hexylmethacrylat (50:50), |
| 0,2 Gt | Hexamethoxymethyl-melamin, |
| 0,2 Gt | Viktoriareinblau FGA (CI 42 595) und |
| 0,2 Gt | Phosphorsäure (85%ig) in |
| 55 Gt | 2-Methoxy-ethanol und |
| 35 Gt | Tetrahydrofuran |

wurde eine elektrochemisch aufgerauhte und anodisierte Aluminiumplatte beschichtet (Schichtgewicht: 0,8 $g/m^2$). Nach dem Belichten unter einer Testvorlage wurde mit folgender Lösung entwickelt:

| | |
|---|---|
| 15 Gt | Pelargonsäure, |
| 10 Gt | Natriumhydroxid, |
| 92 Gt | eines Blockpolymerisats aus 90 % Propylenoxid und 10 % Ethylenoxid und |
| 12 Gt | Natriumtetrapolyphosphat in |
| 550 Gt | Wasser. |

Nach 10 Minuten Erhitzen auf 210 °C zeigte die Platte unter Praxisbedingungen eine vorzügliche Auflagenstabilität.

## Patentansprüche

**1.** Lichtempfindliches Gemisch aus einem Diazoniumsalz-Polykondensationsprodukt und einem polymeren Bindemittel, das seitenständige vernetzende Gruppen der Formel $-CH_2-OR$ enthält, worin R ein Wasserstoffatom, eine niedere Alkyl-, Acyl- oder Hydroxyalkylgruppe ist, dadurch gekennzeichnet, daß das Diazoniumsalz-Polykondensationsprodukt aus wiederkehrenden Einheiten $A-N_2X$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

**2.** Lichtempfindliches Gemisch nach Anspruch 1, dadurch gekennzeichnet, daß das Bindemittel ein Mischpolymerisat mit Einheiten der Formel

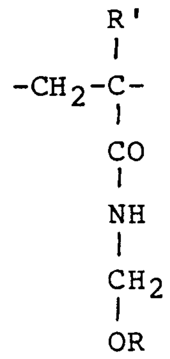

ist, worin

R' ein Wasserstoffatom oder eine Methylgruppe ist und

R die in Anspruch 1 angegebene Bedeutung hat.

**3.** Lichtempfindliches Gemisch nach Anspruch 2, dadurch gekennzeichnet, daß das Mischpolymerisat ferner Einheiten mit seitenständigen Carboxylgruppen enthält.

**4.** Lichtempfindliches Gemisch nach Anspruch 2, dadurch gekennzeichnet, daß das Mischpolymerisat ferner Einheiten mit seitenständigen Carbonsäureamidgruppen enthält.

**5.** Lichtempfindliches Gemisch nach Anspruch 3, dadurch gekennzeichnet, daß das Mischpolymerisat ein Terpolymerisat aus

a) Methacrylsäure oder Acrylsäure,

b) einem Acryl- oder Methacrylamid mit $ROCH_2$-Gruppen am Stickstoff und

c) einem Alkylacrylat oder -methacrylat ist.

**6.** Lichtempfindliches Gemisch nach Anspruch 5, dadurch gekennzeichnet, daß das Terpolymerisat 10 bis 35 Gew.-% aus Acryl- oder Methacrylsäure, 15 bis 60 Gew.-% aus substituiertem Acryl- oder Methacrylamid und 25 bis 75 Gew.-% aus einem Alkylacrylat oder -methacrylat entstandene Einheiten enthält.

**7.** Lichtempfindliches Aufzeichnungsmaterial mit einem Schichtträger und einer lichtempfindlichen Schicht, die ein Diazoniumsalz-Polykondensationsprodukt und ein polymeres Bindemittel mit seitenständigen vernetzenden Gruppen der Formel $-CH_2-OR$ enthält, worin R ein Wasserstoffatom, eine niedere Alkyl-, Acyl- oder Hydroxyalkylgruppe ist, dadurch gekennzeichnet, daß das Diazoniumsalz-Polykondensationsprodukt aus wiederkehrenden Einheiten $A-N_2X$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

## Claims

**1.** Photosensitive composition comprising a diazonium salt polycondensation product and a polymeric binder which contains lateral crosslinking groups of the formula $-CH_2-OR$, in which R is a hydrogen atom, a lower alkyl, acyl or hydroxyalkyl group, wherein the diazonium salt polycondensation product comprises recurring units $A-N_2X$ and B, which are linked by intermediate members, preferably methylene groups derived from carbonyl compounds capable of condensation, where A is the radical of an aromatic diazonium compound capable of condensation with formaldehyde, and B is the radical of a diazonium group-free compound capable of condensation with formaldehyde, in particular of an aromatic amine, a phenol, a phenol ether, an aromatic thioether, an aromatic hydrocarbon, an aromatic heterocyclic compound or an organic acid amide.

**2.** A photosensitive composition as claimed in Claim 1, wherein the binder is a copolymer which comprises units of the general formula

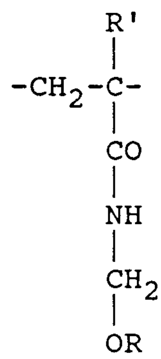

in which
R' denotes a hydrogen atom or a methyl group and
R has the meaning indicated in Claim 1.

**3.** A photosensitive composition as claimed in Claim 2, wherein the copolymer further comprises units possessing lateral carboxyl groups.

**4.** A photosensitive composition as claimed in Claim 2, wherein the copolymer further comprises units possessing lateral carboxamide groups.

**5.** A photosensitive composition as claimed in Claim 3, wherein the copolymer is a terpolymer of
a) a methacrylic acid or acrylic acid,
b) an acrylamide or methacrylamide carrying $ROCH_2$-groups at the nitrogen, and
c) an alkyl acrylate or alkyl methacrylate.

**6.** A photosensitive composition as claimed in Claim 5, wherein the terpolymer comprises 10 to 35 % by weight of units derived from acrylic or methacrylic acid, 15 to 60 % by weight of units derived from substituted acrylamide or methacrylamide, and 25 to 75 % by weight of units derived from an alkyl acrylate or methacrylate.

**7.** A photosensitive recording material comprising a layer support and a photosensitive layer which contains a diazonium salt polycondensation product and a polymeric binder having lateral crosslinking groups of the formula $-CH_2-OR$, in which R is a hydrogen atom, a lower alkyl, acyl or hydroxyalkyl group, wherein the diazonium salt polycondensation product comprises recurring units $A-N_2X$ and B, which are linked by intermediate members, preferably methylene groups derived from carbonyl compounds capable of condensation, where A is the radical of an aromatic diazonium compound capable of condensation with formaldehyde, and B is the radical of a diazonium group-free compound capable of condensation with formaldehyde, in particular of an aromatic amine, a phenol, a phenol ether, an aromatic thioether, an aromatic hydrocarbon, an aromatic heterocyclic compound or an organic acid amide.

**Revendications**

**1.** Composition photosensible à base d'un produit de polycondensation de sel de diazonium et d'un liant polymère qui contient des groupes latéraux réticulants de formule $-CH_2-OR$, dans laquelle R est un atome d'hydrogène, un groupe alkyle, acyle ou hydroxyalkyle inférieur, caractérisée en ce que le produit de polycondensation de sel de diazonium est constitué de motifs répétitifs $A-N_2X$ et B qui sont liés les uns aux autres par des chaînons intermédiaires, de préférence des groupes méthylène, qui sont dérivés de composés carbonyle condensables, A étant le reste d'un composé diazonium aromatique condensable avec le formaldéhyde et a étant le reste d'un composé exempt de groupes diazonium, condensable avec le formaldéhyde, en particulier d'une amine aromatique, d'un phénol, d'un phénol-éther, d'un thioéther aromatique, d'un hydrocarbure aromatique, d'un composé hétérocyclique aromatique ou d'un amide organique.

**2.** Composition photosensible selon la revendication 1, caractérisée en ce que le liant est un copolymère comportant des motifs de formule

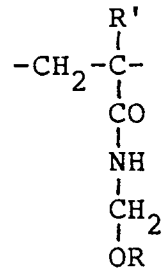

dans laquelle

R' est un atome d'hydrogène ou le groupe méthyle et

R a la signification donnée dans la revendication 1.

**3.** Composition photosensible selon la revendication 2, caractérisée en ce que le copolymère contient en outre des motifs à groupes carboxy latéraux.

**4.** Composition photosensible selon la revendication 2, caractérisée en ce que le copolymère contient en outre des motifs à groupes carbamoyle latéraux.

**5.** Composition photosensible selon la revendication 3, caractérisée en ce que le copolymère est un terpolymère

a) d'acide méthacrylique ou d'acide acrylique,

b) d'un acryl- ou méthacrylamide à groupes $ROCH_2$ sur l'atome d'azote et

c) d'un acrylate ou méthacrylate d'alkyle.

**6.** Composition photosensible selon la revendication 5, caractérisée en ce que le terpolymère contient des motifs constitués de 10 à 35 % en poids d'acide acrylique ou méthacrylique, de 15 à 60 % en poids d'acryl- ou méthacrylamide substitué et de 25 à 75 % en poids d'un acrylate ou méthacrylate d'alkyle.

**7.** Matériau de reprographie photosensible comportant un support de couche et une couche photosensible qui contient un produit de polycondensation de sel de diazonium et un liant polymère à groupes latéraux réticulés de formule $-CH_2-OR$, dans laquelle R est un atome d'hydrogène ou un groupe alkyle, acyle ou hydroxyalkyle inférieur, caractérisé en ce que le produit de polycondensation de sel de diazonium est constitué de motifs répétitifs $A-N_2X$ et B qui sont liés les uns aux autres par des chaînons intermédiaires, de préférence des groupes méthylène, qui sont dérivés de composés carbonyle condensables, A étant le reste d'un composé diazonium aromatique condensable avec le formaldéhyde et B étant le reste d'un composé exempt de groupes diazonium, condensable avec le formaldéhyde, en particulier d'une amine aromatique, d'un phénol, d'un phénol-éther, d'un thioéther aromatique, d'un hydrocarbure aromatique, d'un composé hétérocyclique aromatique ou d'un amide organique.